# EUROPEAN PATENT SPECIFICATION

(11) **EP 0 802 591 B1**
(45) Date of publication and mention of the grant of the patent: **05.12.2001**
(21) Application number: 97302520.8
(22) Date of filing: 14.04.1997
(51) Int. Cl.: H01S 5/02, G11B 7/125

(54) **Laser diode package having an optical power monitoring function**
Diodenlasereinheit mit optischer Leistungsüberwachung
Module laser à diode avec possibilité de surveillance de la puissance optique

(30) Priority: 18.04.1996 KR 9611754
(43) Date of publication of application: 22.10.1997
(73) Proprietor: Samsung Electronics Co., Ltd., Suwon City, Kyungki-do (KR)
(72) Inventor: Kim, Il, Paldal-gu, Suwon-city, Kyungki-do (KR); Park, Chung-Seong, Paldal-gu, Suwon-city, Kuungki-do (KR)
(74) Representative: Chugg, David John

(56) References cited:
- PATENT ABSTRACTS OF JAPAN vol. 013, no. 413 (E-820), 12 September 1989 -& JP 01 151285 A (NEC CORP), 14 June 1989,
- PATENT ABSTRACTS OF JAPAN vol. 012, no. 049 (E-582), 13 February 1988 -& JP 62 196881 A (FUJI PHOTO FILM CO LTD), 31 August 1987,
- PATENT ABSTRACTS OF JAPAN vol. 016, no. 535 (E-1288), 5 November 1992 -& JP 04 199890 A (MITSUBISHI ELECTRIC CORP), 21 July 1992,
- HYUN-KUK SHIN ET AL.: "Vertical-cavity surface-emitting lasers for optical data storage" JAPANESE JOURNAL OF APPLIED PHYSICS, vol. 35, no. 1B, January 1996, pages 506-507, XP002057896

## Description

The present invention relates to a laser diode package having a monitor diode for monitoring an optical power of a laser diode, and more particularly, to a laser diode package having an optical power monitoring function for shielding ambient light which can induce a mis-operation of a monitor diode.

A general optical disc system such as a compact disc player projects laser light onto the recording surface of a disc and reads information recorded on the disc. In such an optical disc system, if an output of the laser light varies, an error may be generated when a signal is read from the disc. Thus, the optical disc system includes an automatic laser power control (ALPC) to stably control the output of the laser light.

A semiconductor laser diode used as a light source in a compact disc player has a poor temperature characteristic. That is, as temperature rises, optical power decreases, while as temperature falls, optical power increases. The ALPC circuit in the optical disc system uses a photodiode to monitor an optical power of such a laser diode, and controls a driving current of the laser diode according to the current flowing through the photodiode.

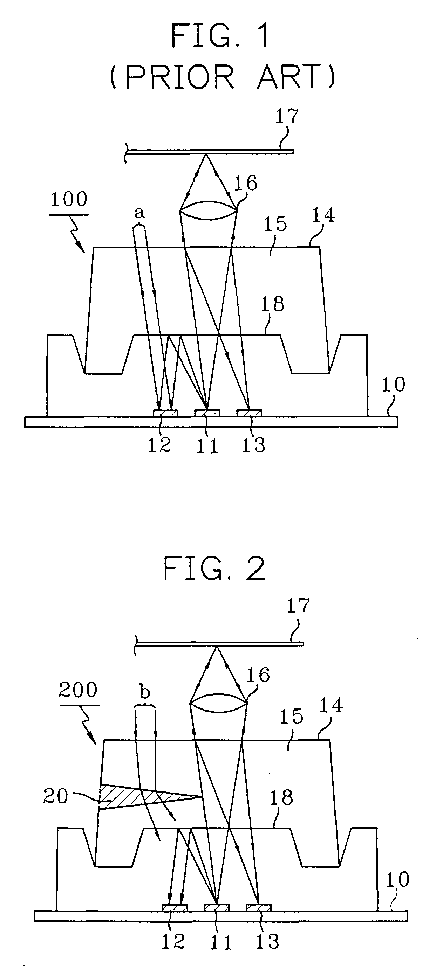

Figure 1 shows the structure of a conventional laser diode package. The laser diode package 100 of Figure 1 includes a laser diode 11, a monitor diode 12 for monitoring an optical power of the laser diode 11 and a signal detection diode 13 for detecting information recorded on a disc 17. The laser diode 11, the monitor diode 12 and the signal detection diode 13 are mounted on a lead frame base 10. Most of the light emitted from the laser diode 11 passes through a transparent plate 15 and then is incident to an objective lens 16. Part of the light emitted from the laser diode 11 is reflected from a surface 18 of the transparent plate 15 and then is incident to the monitor diode 12. The light incident to the objective lens 16 is focused at a point on the disc 17 by the objective lens 16. The light reflected from the disc 17 enters into the laser diode package 100 via the objective lens 16.

The transparent plate 15 of the laser diode package 100 has a structure in which a holographic optical element 14 is installed on or near the surface opposing the objective lens 16, and is fabricated by injection moulding. The holographic optical element 14 of the transparent plate 15 diffracts the light incident from the objective lens 16 and the light diffracted by the holographic optical element 14 is incident to the signal detection diode 13.

The monitor diode 12 outputs a monitor current proportional to the quantity of the incident light to an ALPC circuit (not shown). The well-known ALPC circuit adjusts the driving current of the laser diode 11 uniformly according to the monitor current output from the monitor diode 12.

When the disc 17 wobbles or ambient light "a" is incident to the monitor diode 12, the monitor diode 12 monitors the quantity of the light incident from the laser diode 11 to be recognized as more than the actual quantity.

Patent Abstracts of Japan, Volume 16, No. 535 (E-1288), 5 November 1992 & JP-A-04199890 (Mitsubishi Electric Corp.) discloses a semiconductor laser device in a diode package having a monitoring photodiode, with light emitted from the laser diode being passed through a beam splitter such that a part of the light from the laser diode is emitted from the package, and another part of the light is directed towards the monitoring photodiode. The photodiode is effectively shielded from ambient light by a cap having slanting surfaces, with a mirrored effect.

With a view to solving or reducing the above problem, it is an aim of the present invention to provide a laser diode package having an optical power monitoring function for shielding ambient light which can accurately monitor an optical power of a laser diode.

According to the present invention as defined in claim 1, there is provided a laser diode package having an optical power monitoring function comprising: a laser diode; an optical member having a projection window for advancing part of the light emitted from said laser diode to a desired direction and a reflection surface from which another part of the light emitted from said laser diode is reflected; a monitor diode for receiving said another part of the light reflected from said reflection surface of said optical member in order to monitor an optical power of the light emitted from said laser diode, said monitor diode outputting a monitor current proportional to the intensity of the incident light; and the package being characterised in that shield means are provided, the shield means consisting of a slot in the optical member of the laser diode package and arranged to shield the monitor diode from ambient light so that the incident ambient light on the monitor diode has an extremely small intensity such that the magnitude of the monitor current is not changed.

Preferably said shield means is provided on an area away from the optical path taken by light projected via the projection window of the optical member.

Said shield means is preferably surface treated to shield the ambient light.

Preferably, said surface of the shield means is roughened.

Preferably, said shield means extends so as to block or scatter any light not following said optical path.

For a better understanding of the invention, and to show how embodiments of the same may be carried into effect, reference will now be made, by way of example, to the accompanying diagrammatic drawings, in which:
Figure 1 is a view showing the structure of a conventional laser diode package; and
Figure 2 is a view showing the structure of a laser diode package according to the present invention.

A preferred embodiment of the present invention will be described in detail with reference to the accompanying drawings.

Figure 2 shows the structure of a laser diode package 200 according to an embodiment of the present invention. The elements having the same reference numerals as those of Figure 1 have the same functions as those of Figure 1. The transparent plate 15 of laser diode package 200 includes a slot 20 having an optical characteristic for scattering incident light. The slot 20 has a size and a shape by which portions, except from an optical path where the light emitted from the laser diode 11 is incident on the objective lens 16, can be shielded.

In the laser diode package 200 having the above structure, ambient light "b" passes through the slot 20 and simultaneously scatters. Therefore, the ambient light "b" incident to the monitor diode 12 is extremely small in intensity. That is, the ambient light has such a magnitude that the magnitude of the monitor current is not changed. Therefore, only the light of the laser diode 11 reflected from the surface 18 of the transparent plate 15 is substantially incident to the monitor diode 12. Thus, the monitor diode 12 outputs the monitor current proportional to an optical power of the laser diode 11. Also, the surface of the slot 20 in the transparent plate 15 is treated so as to increase the shielding effect, to be gross to shield ambient light. For instance, the surface of the slot 20 may be roughened to aid light scattering.

As described above the laser diode package having an optical power monitoring function according to the present invention prevents a mis-operation of the monitor diode due to the ambient light.

While only certain embodiments of the invention have been specifically described herein, it will be apparent that numerous modifications may be made thereto without departing from the scope of the invention as defined in claim 2.

## Claims

1. A laser diode package having an optical power monitoring function comprising:
a laser diode (11);
an optical member (15) having a projection window for advancing part of the light emitted from said laser diode to a desired direction and a reflection surface (18) from which another part of the light emitted from said laser diode is reflected;
a monitor diode (12) for receiving said another part of the light reflected from said reflection surface (18) of said optical member (15) in order to monitor an optical power of the light emitted from said laser diode (11), said monitor diode outputting a monitor current proportional to the intensity of the incident light; and
the package being **characterised in that** shield means (20) are provided, the shield means (20) consisting of a slot in the optical member (15) of the laser diode package and arranged to shield the monitor diode (18) from ambient light so that the incident ambient light on the monitor diode has an extremely small intensity such that the magnitude of the monitor current is not changed.

2. The laser diode package of claim 1 or 2, wherein said shield means (20) is provided on an area away from the optical path taken by light projected via the projection window of the optical member (15).

3. The laser diode package having an optical power monitoring function according to claim 1 or 2, wherein said shield means (20) is surface treated to shield the ambient light.

4. The laser diode package of claim 3, wherein said surface of the shield means (20) is roughened.

5. The laser diode package as claimed in claim 2, wherein said shield means (20) extends so as to scatter any light not following said optical path.

## Patentansprüche

1. Diodenlasereinheit mit einer optischen Leistungsüberwachungsfunktion, die folgendes umfasst:
- einen Diodenlaser (11) ;
- ein optisches Bauelement (15) mit einem Projektionsfenster zur Zuführung eines Teils des Lichtes, das von dem Diodenlaser (11) in eine gewünschte Richtung emittiert wird und einer reflektierenden Oberfläche (18), von welcher der andere Teil des Lichtes, das von dem Diodenlaser (11) emittiert wird, reflektiert wird;
- eine Überwachungsdiode (12) zum Empfang des anderen Teil des Lichtes, welches von der reflektierenden Oberfläche (18) des optischen Bauelementes (15) reflektiert wird, um eine optische Leistung des Lichtes, welches von dem Diodenlaser (11) emittiert wird zu kontrollieren, wobei die Überwachungsdiode (12) einen Überwachungsstrom ausgibt, der proportional zur Intensität des einfallenden Lichtes ist; und
- wobei die Einheit **dadurch gekennzeichnet ist, dass** sie mit einer Abschirmeinrichtung (20) versehen ist, wobei diese Abschirmeinrichtung (20) aus einem Spalt in dem optischen Bauelement (15) der Diodenlasereinheit besteht und zum Schutz der Überwachungsdiode so angeordnet ist, dass das auf die Überwachungsdiode (12) einfallende Umgebungslicht eine derartig extrem geringe Intensität besitzt, dass die Größe des Überwachungsstromes nicht verändert wird.

2. Diodenlasereinheit nach Anspruch 1 oder 2, bei der die Abschirmeinrichtung (20) in ein Gebiet eingebracht wird, abseits von dem optischen Pfad, welchen das Licht durch Projektion durch das Projektionsfenster des optischen Bauelementes (15) geht.

3. Diodenlasereinheit mit einer optischen Leistungsüberwachungsfunktion nach Anspruch 1 oder 2, bei der die Oberfläche der Abschirmeinrichtung (20) behandelt ist, um gegen das Umgebungslicht abzuschirmen.

4. Diodenlasereinheit nach Anspruch 3, bei der die Oberfläche der Abschirmeinrichtung (20) aufgeraut ist.

5. Diodenlasereinheit nach Anspruch 2, bei der die Abschirmeinrichtung (20) so weit ausgedehnt ist, dass alles Licht, das nicht dem optischen Pfad folgt gestreut wird.

## Revendications

1. Module de diode laser comportant une fonction de contrôle de la puissance optique, comprenant:
une diode laser (11);
un élément optique (15) possédant une fenêtre de projection pour la partie de la lumière émise par ladite diode laser, qui avance dans une direction désirée, une surface réfléchissante (18) qui réfléchit une autre partie de la lumière émise par ladite diode laser;
une diode de contrôle (12) pour recevoir les autres parties de la lumière réfléchie par ladite surface réfléchissante (18) dudit élément optique (15) pour contrôler une puissance optique de la lumière émise par ladite diode laser (11), ladite diode de contrôle délivrant un courant de contrôle proportionnel à l'intensité de la lumière incidente; et
le module étant **caractérisé en ce que** des moyens de blindage (20) sont prévus, les moyens de blindage (20) étant constitués par une fente dans l'élément optique (15) du module de la diode laser et disposés de manière à protéger la diode de contrôle (18) vis-à-vis de la lumière ambiante de sorte que la lumière ambiante incidente, qui rencontre la diode de contrôle, possède une intensité extrêmement faible de telle sorte que l'intensité du courant de contrôle n'est pas modifiée.

2. Module de diode laser selon la revendication 1 ou 2, dans lequel lesdits moyens de blindage (20) sont prévus dans une zone écartée du trajet optique suivi par la lumière projetée, par l'intermédiaire de la fenêtre de projection de l'élément optique (15).

3. Module de diode laser possédant une fonction de contrôle de puissance optique selon la revendication 1 ou 2, dans lequel la surface desdits moyens de blindage (20) est traitée de manière à réaliser une protection vis-à-vis de la lumière ambiante.

4. Module de diode laser selon la revendication 3, dans lequel ladite surface des moyens de blindage (20) est rugueuse.

5. Module de diode laser selon la revendication 2, dans lequel lesdits moyens de blindage (20) s'étendent de manière à disperser toute lumière qui ne suit pas ledit trajet optique.
